# EUROPEAN PATENT SPECIFICATION

(11) **EP 0 893 223 B1**
(45) Date of publication and mention of the grant of the patent: **18.09.2002**
(21) Application number: 97942963.6
(22) Date of filing: 13.10.1997
(51) Int. Cl.: B29C 39/04, B29C 35/02, B29C 59/04, B29C 33/38

(54) **A METHOD FOR OBTAINING A SEAMLESS ENGRAVING CYLINDER FOR PRODUCING SHEETS WITH OPTICAL EFFECTS, AND A PLANT INCLUDING SAID CYLINDER**
VERFAHREN ZUM HERSTELLEN EINER NAHTLOSEN GRAVURWALZE ZUR HERSTELLUNG VON FOLIEN MIT OPTISCHEN EFFEKTEN, UND ANLAGE MIT EINER SOLCHEN GRAVURWALZE
PROCEDE DE FABRICATION D'UN CYLINDRE DE GRAVURE POUR L'OBTENTION DE FEUILLES AVEC EFFETS OPTIQUES, ET INSTALLATION COMPORTANT UN TEL CYLINDRE DE GRAVURE

(30) Priority: 14.10.1996 ES 9602158; 30.09.1997 ES 9702038
(43) Date of publication of application: 27.01.1999
(73) Proprietor: Grifoll Casanovas, Juan, 08228 Terrassa (Barcelona) (ES)
(72) Inventor: Grifoll Casanovas, Juan, 08228 Terrassa (Barcelona) (ES)
(74) Representative: Manresa Medina, Enrique
(86) International application number: ES9700248
(87) International publication number: WO98016362

(56) References cited:
- EP-A- 0 306 070
- EP-A- 0 623 440
- US-A- 4 250 135
- US-A- 4 840 757

## Description

The present invention refers to a method for obtaining a seamless engraving cylinder for producing sheets with optical effects, and to a plant including said cylinder.

There are already at present several processes and their corresponding plants to provide on the sheets light diffraction and/or reflection optical effects, said sheets being coated with a layer of transparent resin or plastics material conveniently worked or engraved by means of pressure and heat or by contact and polymerisation at the same time to form a coating by way of microlenses or a hologram, said sheets also possibly receiving the impression of various patterns and/or illustrations which are visualized through said layer contributing to said optical effects or being a complement for them in the sheet produced.

The object of the US-A-4 840 757 patent is a procedure for obtaining holographical patterns and comprises a supporting sheet on which a radiation-curable resin is deposited and became engraved with the holographical pattern when being pressed against a master cylinder. Concurrently when the laminar support and the resin are conveyed on the rotary engraving cylinder, a resin-curing electronic beam is irradiated. This patent has as an object to duplicate patterns at a higher scale from an engraved film to the surface of a sheet, of a garment or to coils with pressurized adhesive for the manufacture of labels and decals.

The object of the EP-A-0 623 440 patent is also a method for manufacturing a reflex-reducing TV screen. This method comprises a plant with an ultraviolet rays-transparent rotating master-cylinder having inside an ultraviolet-rays source and a curable substance arranged on a flat support is concurrently engraved and cured with this master-cylinder.

On the other hand, cylinder in the above Document EP-A-0 623 440 is not seamless but the peripheral length of the cylinder mould is approximately the same length of the substrate. Hence, by rolling the cylinder just once over the substrate, a seamlessely replicate surface of the roller is obtained. However, a seamless continuous sheet can not be engraved using such method.

US-A-4,250,135 discloses a roller for producing continuous sueded or grit type finish, and a method of making the same. The method comprises rolling an adhesive-coated cylinder over grit spread on a planar surface. The cylinder covered by the grid is then further coated with a flexible material such as plastisol and after curing this coating is removed intact with the impression of the grit surface on the inner surface of this master sleeve. Then, an electro-forming process deposits a reversal seamless metal sleeve over the master sleeve. The seamless metal sleeve is finally fixed on a finished metal roll apt to engraving an embossed suede or grit surface on a strip of plastic.

EP-A-0 306 070 discloses a process to produce a heat-engraving cylinder for thermoplastic sheets wherein a laminar product with various seams is first obtained by adhering various positive engraved juxtaposed panels obtained from negative moulds of, for example, natural leather. Such seams are then masked with a small positive engraved roller. A cylinder with a seam is then obtained by bending the laminar product and adhering its ends producing said seam, and again this seams is masked with the small positive engraved roller. Finally the seamless cylinder is used in a moulding process to obtain a negative engraving seamless cylinder.

However, in spite of the two last documents using a seamless engraving cylinder which may be acceptable for reproducing, for example, a "grit" or "natural leather" surface, where there are no definite contours of different relieves or geometric forms to keep, cylinders produced by such methods are clearly ineffective to accurately reproduce a micro-relief surface aimed to produce optical effects as microlenses or holograms.

These known processes and plants do generally determine a high price of the product obtained due to the low output, without the end result of the already processed sheet being as perfect as would be desired, this limiting its ulterior use to be applied for the manufacture of various products.

It is the object of this invention to provide a rational and practical plant for obtaining sheets with optical effects and with a practically perfect engraving, in such a way as to achieve optimal effects with a practical plant with a high operating speed in order to achieve the manufacture of this kind of sheets at a competitive price.

This object is achieved by the method according to claim 1 and by the plant according to claim 2.

The assembly of resin printing, engraving and polymerising means forms a compact unit allowing their arrangement in line on a rotary machine and also allowing to achieve the necessary register with the other patterns and colors to be printed on the sheet by means of the rotary machine.

The fact that in the present case pressure and heat are not needed for the engraving and polymerising of the resin allows to incorporate said assembly into a rotary machine and to operate at the speed of the latter.

It is advantageous to effect before the engraving and polymerising of the resin a partial (superficial) polymerisation of the latter in order to prevent its penetration into imperfections that could be possibly present in the finished surface of the engraving cylinder and mainly in its longitudinal pseudoseam.

A preferred characteristic of the plant is the arrangement at the discharge of the sheet already engraved with the optical effects of independent means providing it with a treatment for the protection of the engraved surface, such as a metalization.

Preferred embodiments of the plant are defined in the dependent claims.

The engraving cylinder used in this plant allows to obtain a continuous engraving not showing the lines that could be observed due to the joints between plate and plate of the conventional metallic cylinder that was used as an engraving die.

These and other characteristics will be best made apparent by the following detailed description whose understanding will be made easier by the accompanying five sheets of drawings showing some practical embodiments cited only by way of examples not limiting the scope of the present invention.

In the drawings:

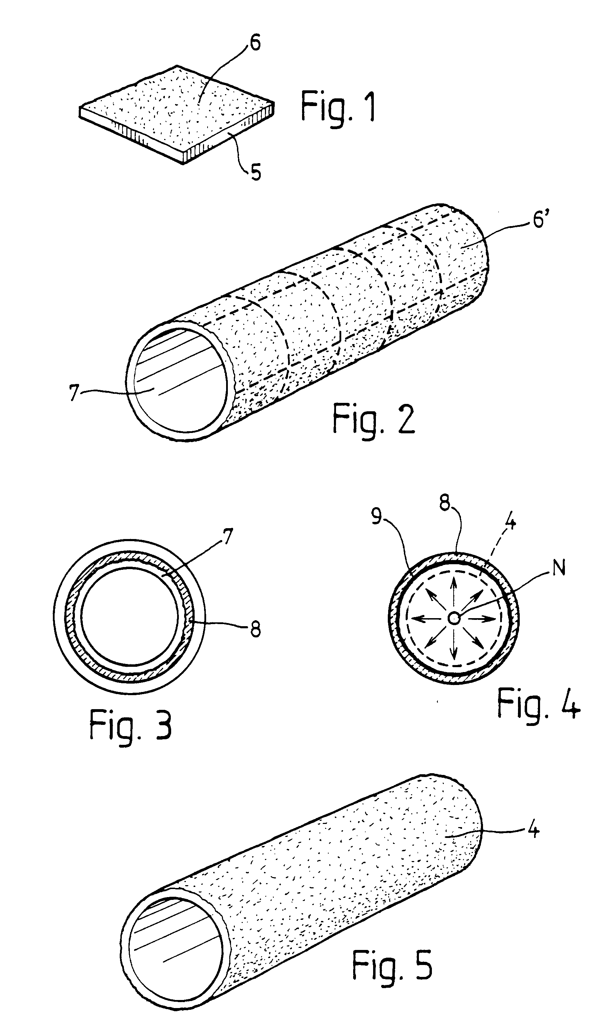

Figs. 1 to 5 correspond to the schematical representation of the construction of the integral nickel engraving cylinder,
Figs. 6 to 10 are the schematical representation of another embodiment of the integral nickel engraving cylinder,
Figs. 11 and 12 show schematically the forming of the integral silicone engraving cylinder,
Figs. 13 to 15 represent schematically the construction of the engraving information carrying cylinder with the checkered longitudinal joint,
Fig. 16 illustrates in a side elevation another alternative embodiment of said cylinder,
Fig. 17 illustrates in a schematic side elevation the printing-engraving-polymerising assembly using an engraving cylinder formed, differently from the present inrention, by two longitudinal and independent half-plates,
Fig. 18 illustrates in a schematic side elevation the printing-engraving-polymerising assembly carrying out the printing of the resin directly onto the engraving cylinder,
Fig. 19 shows in a schematic view the incorporation of said assembly into a rotary machine,
Fig. 20 shows in a perspective view an engraving cylinder not formed according to the present invention, with the emulsion on its periphery,
Fig. 21 is a cross-sectional close view of the engraving cylinder of Fig. 20,
Fig. 22 shows in a schematic side elevation the printing-engraving-polymerising assembly carrying out the printing of the resin onto the sheet, and
Fig. 23 shows schematically the incorporation of the assembly of Fig. 22 into a flexographic printer.

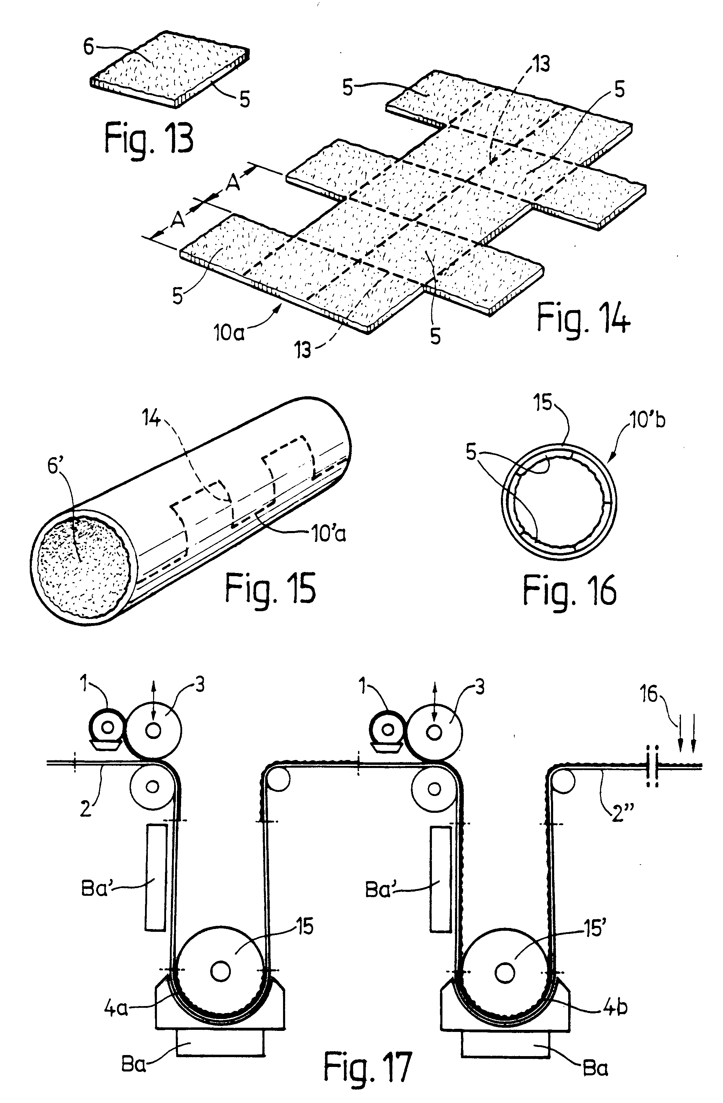

According to the drawings, the delivery (or printing) of the resin -1- to the sheet -2- is effected by rotogravure (Fig. 17) by means of cylinder -3-, and the engraving and polymerising of the resin is carried out at the same time by using an engraving cylinder -4-, -4'- or -4"- not having any joints, a bank -Ba- of ultraviolet ray emitters being used as the polymeriser. With -Ba'- are indicated respective banks also of ultraviolet ray emitters for obtaining a prepolymerisation in the resin.

The engraving cylinder -4- is formed by an integral metal piece not having any joints, and is obtained from a square plaquette -5- of reduced dimensions having on one of its surfaces the engraving information -6-; said engraving information being transferred from said plaquette to a cylinder -7- of plastics material, such as methacrylate, said transfer being carried out by means of a thermal repeating machine and with pressure thus providing the outer surface of said cylinder with an engraving information -6'- that is a multiple of the engraving information provided on plaquette -5-.

From this cylinder -7- is obtained by molding a silicone cylinder -8- with the engraving information on its inner surface, and from this latter and by electroforming and after a previous metalization -9- of said inner surface the metal engraving cylinder -4- is finally obtained, this latter being made of nickel -N-.

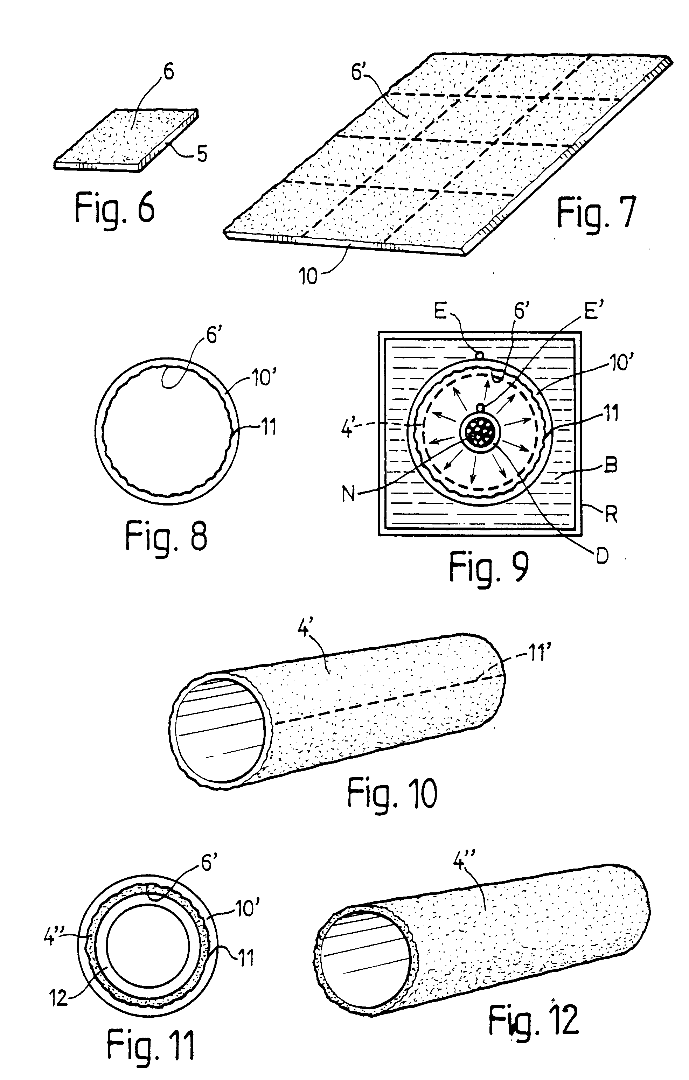

By means of plaquette -5- it is also possible to obtain an integral, metallic engraving cylinder -4'-(Fig. 10) by transferring the engraving information -6-to one of both surfaces of a bigger plate -10- also by means of a repeating machine.

This plate -10- is wound thus forming a cylinder -10'- trying to conceal as much as possible the longitudinal seam or joint -11- of the latter, and in such a way as to have the engraving information -6'- on its inner surface.

From this inner surface of cylinder -10'- the engraving cylinder -4'- is obtained by electroforming, for such a purpose introducing said cylinder -10'- into a vessel -R- with the corresponding bath -B- and coaxially arranging inside said cylinder a grid-walled reservoir -D- into which the nickel -N- is introduced, the cylinder -10'- and said reservoir being connected to the corresponding electrodes -E- and -E'-, thus achieving the formation of the engraving cylinder -4'- on the inner surface of cylinder -10'-, said engraving cylinder showing a slight longitudinal line -11'- which will be almost unperceivable and corresponds to the reproduction of joint -11- of cylinder -10'-.

From cylinder -10'- with the engraving information -6'- on its inner surface it is also possible to obtain by molding an integral engraving cylinder -4''- made of silicone (Fig. 11) that can be opaque or transparent, by arranging concentrically to cylinder -10'- a coaxial cylinder -12- and pressure stuffing the silicone between both said cylinders after previously having extracted by vacuum the air possibly comprised in its mass. Also a quartz engraving cylinder can be obtained by molding. Cylinder -10'- with the engraving information can also be obtained by joining the juxtaposed plates -5- by means of laser welding thereby forming plate -10a- whose joints -13- are barely noticeable since they are reduced to practically one tenth of a millimeter. The longitudinal edges of plate -10a- have a checkered profile, each length -A- corresponding to one of the component plaquettes -5- so that when forming the cylinder -10'a-the longitudinal joint -14- is still farther concealed (Fig. 15).

Also the cylinder with the engraving information can be obtained, differently from the present invention, by coupling plates -5- to a magnetized carrier cylinder -15- thus obtaining cylinder -10'b-(Fig. 16).

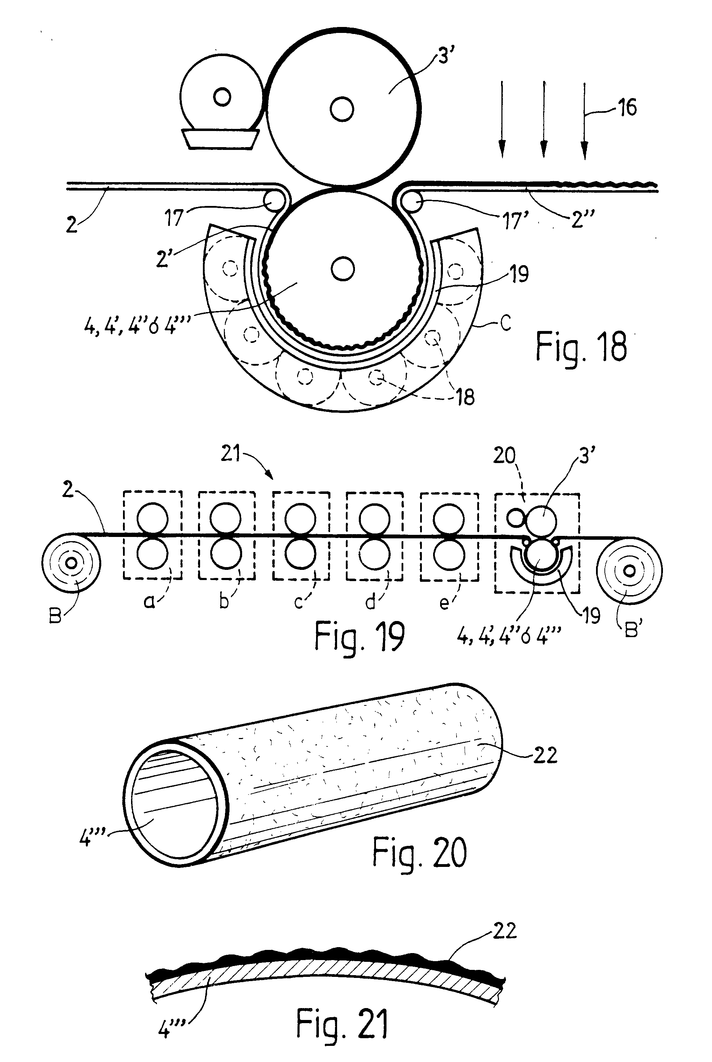

According to Figs. 18 and 19 this plant comprises a reel -B- formed by sheet -2- made of transparent resin or plastics material (e.g., polyester) or paper guided by rolls -17- towards engraving cylinder -4-, -4'-, -4"- or -4'''- (e.g., holographic), the resin being impressed by means of flexography cylinder -3'- directly contacting upon the engraving cylinder, said sheet hence reaching this cylinder after having already been printed -2'- with the resin and before being applied against it.

Outside engraving cylinder -4-, -4'-, -4"- or -4'''-are arranged ultraviolet ray emitters -18- forming the resin polymerising element, said emitters comprising a filter -19- for the infrared rays. The engraving and the polymerisation are thus obtained at the same time.

From engraving cylinder -4-, -4'-, -4"- or -4'''-exits guided by rolls -17'- sheet -2"- already printed and engraved, and on said sheet is thereupon applied a protecting treatment which can consist, for example, in a metalization -16- or in an application of a liquid titanium solution, after which said sheet is wound into a reel -B'- for its commercialization.

The engraving cylinder -4-, -4'-, -4"- or -4'''-will be conveniently cooled from inside, and the ultraviolet ray emitters -18- will be placed inside a properly ventilated chamber -C-.

If the engraving cylinder is transparent the ultraviolet ray emitters can ba arranged in its inside.

The assembly of the printing -3- or -3'-, engraving -4-, -4'-, -4"- or -4'''- and polymerising -18- means forms a compact unit -20- that will be arranged in line on a rotary machine -21- thus allowing to obtain the register of the parts engraved with optical effects as if they were the very patterns and colors to be printed on the sheet by means of the corresponding cylinder sets a, b, c, d and e comprised in the rotary machine.

The engraving cylinder -4'''- (Fig. 20) of any material, even nonmetallic, is not formed according to the present invention, since it will have as the engraving die the peripheral coat of the own emulsion -22- provided with the corresponding engraving information and conveniently hardened.

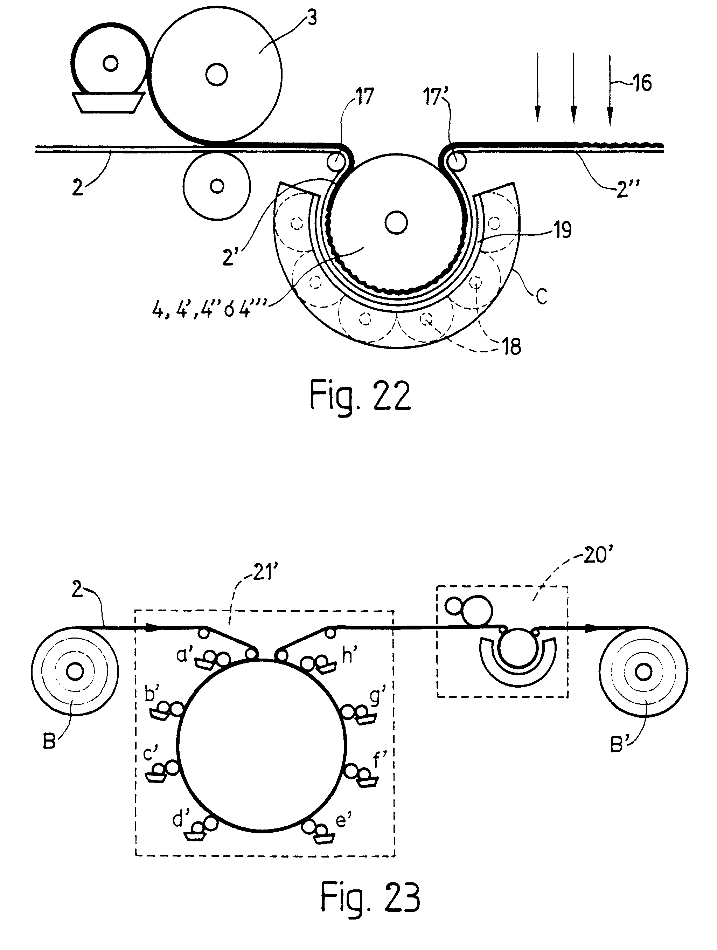

If the printing of the resin onto the sheet is carried out by rotogravure the printing will be then effected upon the sheet as shown in Fig. 22, cylinder -3-being a rotogravure cylinder. Also in this case if the engraving cylinder is transparent the ultraviolet ray emitters can be arranged in its inside.

Fig. 23 illustrates the incorporation of the printing-engraving-polymerising assembly -20'- (wherein the printing of the resin is effected onto sheet -2-) into a flexographic printer -21'- printing eight colors a', b', c', d', e', f', g' and h' around its central drum.

The above-mentioned engraving cylinders -4-, -4'-, -4''- and -4'''- allow to obtain the reproduction of the optical effects on the corresponding sheet -2- in a continuous way without a breach of continuity being practically noticeable in said engraved effects.

A simplified construction of the engraving cylinder is herewith mentioned, which will be formed, differently from the present invention, by two independent halves formed by respective plates -4a- and -4b- transversally arcuate in semicircular shape. In this case the engraving of sheet -2- (Fig. 17) will be obtained in two stages within the plant, whereby cylinder -15- carrying plate -4a- will act in a first stage and cylinder -15'- carrying the other plate -4b- will act in a second stage, in such a way that after the two stages the patterns corresponding to the total engraving cylinder will have been engraved.

In those cases where the cylinder with the engraving information has this latter on its outer surface these cylinders will be apt to be used as engraving cylinders.

## Claims

1. A method for obtaining a seamless engraving cylinder for producing sheets with optical effects, comprising electro-formig said engraving cylinder (4) with the desired pattern on its outer surface using as a mould the engraved inner surface of a flexible cylinder (8) obtained by moulding it on a cylinder (7) of a rigid plastic material, used as a model including engraving information (6') on the outer surface thereof, said engraving information (6') being received by said cylinder (7) by reproducing engraving information (6) provided on a plaquette (5) several times on said cylinder (7) by pressure and heat using a repeating or recombining machine.

2. A plant for obtaining sheets with optical effects comprising:
printing means for depositing a layer of transparent resin on a sheet (2); and
engraving means for engraving by contact various patterns and/or illustrations on said layer of resin, and polymerising means for polymerising the engraved layer of resin to produce the optical effects, said engraving and polymerising means actuating at the same time,
wherein said engraving means comprises a seamless engraving cylinder (4) obtained according to Claim 1.

3. A plant, according to Claim 2, wherein said printing means includes rotogravure, serigraphy, rotary serigraphy, flexography or offset.

4. A plant, according to Claim 2, wherein said printing means include a flexography cylinder (3') contacting directly upon the engraving cylinder (4) so that the layer of transparent resin is deposited on said engraving cylinder (4) before contacting the sheet (2).

5. A plant, according to Claim 2, wherein said printing means include a rotogravure cylinder (3) so that the layer of transparent resin is deposited on said sheet (2) before contacting the engraving cylinder (4).

6. A plant, according to Claim 2, wherein said printing, engraving and polymerising means form a compact assembly (20) that is arranged in line on a rotary machine (21) which includes other printing means for printing other motives and colours (a, b, c, d and e) to said sheet, said assembly (20) being able to obtain the engraving in register with said other motives and colours (a, b, c, d and e).

7. A plant, according to Claim 2, wherein said polymerising means includes ultraviolet rays (18) or an electron generator.

8. A plant, according to Claim 7, wherein said ultraviolet rays comprise a filter (19) for the infrared rays.

9. A plant, according to Claim 7, wherein said polymerising means are arranged outside of said engraving cylinder (4).

## Patentansprüche

1. Verfahren zur Herstellung eines nahtlosen Tiefdruckzylinders zur Herstellung von Folien mit optischen Effekten, wobei man auf dem Tiefdruckzylinder (4) an dessen Außenfläche das gewünschte Muster durch Elektrogravur aufbringt, wobei man als Form die gravierte Innenfläche eines flexiblen Zylinders (8) verwendet, der durch Formung auf einem Zylinder (7) aus steifem Kunststoffmaterial erhalten und als Modell mit Gravurinformation (6') an dessen Außenoberfläche verwendet wurde, wobei der Zylinder (7) die. Gravurinformation (6) dadurch erhielt, daß man die auf einer Plakette (5) vorliegende Gravurinformation (6) mehrmals auf dem Zylinder (7) unter Anwendung von Druck und Wärme mittels einer Repetier- oder Rekombinationsmaschine reproduzierte.

2. Anlage zur Herstellung von Folien mit optischen Effekten, die:
Druckmittel zur Aufbringung einer Schicht aus lichtdurchlässigem Harz auf einer Folie (2) sowie Gravurmittel zur Kontaktgravur verschiedener Muster und/oder Illustrationen auf der genannten Harzschicht sowie Polymerisationsmittel zur Polymerisation der bedruckten Harzschicht zur Erzielung der genannten optischen Effekte aufweist, wobei die Gravier- und Polymerisationsmittel gleichzeitig wirken,
und die Gravurmittel einen nach Anspruch 1 erhaltenen nahtlosen Tiefdruckzylinder (4) einschliessen.

3. Anlage gemäss Anspruch 2, wobei als Druckmittel Rotationstiefdruck, Siebdruck, Rotationssiebdruck, Flexodruck oder Offsetdruck verwendet werden.

4. Anlage gemäss Anspruch 2, wobei als Druckmittel ein Flexodruckzylinder (3') verwendet wird, der den Tiefdruckzylinder (4) direkt berührt, so daß die Schicht aus lichtdurchlässigem Harz auf dem Tiefdruckzylinder (4) abgewälzt wird, bevor die Folie (2) bedruckt wird.

5. Anlage nach Anspruch 2, wobei als Druckmittel u.a. ein Rotations-Tiefdruckzylinder (3) verwendet wird, so daß die Schicht aus lichtdurchlässigem Harz auf der Folie (2) abgewälzt wird, bevor der Tiefdruckzylinder (4) berührt wird.

6. Anlage nach Anspruch 2, wobei die Druck-, Gravur- und Polymerisationsmittel einen kompakten Zusammenbau (20) bilden, der auf einer Rotationsmaschine (21) in einer Reihe angeordnet ist, die weitere Druckmittel zum Bedrucken der Folie mit weiteren Motiven und Farben (a, b , c, d und e) aufweist, wobei der Zusammenbau (20) zum passergenauen Bedrucken mit den gennanten weiteren Motiven und Farben (a, b, c, d und e) in der Lage ist.

7. Anlage nach Anspruch 2, wobei die genannten Polymerisationsmittel Ultraviolettbestrahlung (18) oder einen Elektronengenerator einschliessen.

8. Anlage nach Anspruch 7, wobei die Ultraviolettbestrahlung einen Filter (19) für Infrarotstrahlen einschliesst.

9. Anlage nach Anspruch 7, wobei die genannten Polymerisationsmittel außerhalb des genannten Tiefdruckzylinders (4) angeordnet sind.

## Revendications

1. Une méthode pour obtenir un cylindre à graver sans soudure pour produire des feuilles ayant des effets optiques, comprenant l'électroformage de ce cylindre à graver (4) avec le dessin souhaité sur sa surface extérieure en utilisant comme moule la surface intérieure gravée d'un cylindre souple (8) obtenu par son moulage sur un cylindre (7) en matière plastique rigide utilisé comme modèle qui comporte les informations de gravure (6') sur sa surface extérieure, ces informations de gravure (6') étant reçues par ce cylindre (7) par la reproduction des informations de gravure (6) se trouvant sur une petite plaque (5) plusieurs fois sur ce cylindre (7) par la pression et la chaleur en utilisant une machine qui répète ou recombine.

2. Une installation pour obtenir des feuilles ayant des effets optiques, comprenant:
des moyens d'impression pour déposer une couche de résine transparente sur une feuille (2); et
des moyens pour graver par contact plusieurs dessins et/ou illustrations sur cette couche de résine et des moyens pour polymériser la couche de résine gravée pour produire les effets optiques, ces moyens pour graver et polymériser agissant en même temps,
dans laquelle ces moyens pour graver comportent un cylindre à graver sans soudure (4) obtenu conformément à la Revendication 1.

3. Une installation, conformément à la Revendication 2, dans laquelle ces moyens d'imprimerie comprennent la rotogravure, la sérigraphie, la sérigraphie rotative, la flexographie ou l'offset.

4. Une installation conformément à la Revendication 2, dans laquelle ces moyens d'imprimerie comportent un cylindre à flexographie (3') étant en contact direct avec le cylindre à graver (4) de sorte que la couche de résine transparente est déposée sur ce cylindre à graver (4) avant d'entrer en contact avec la feuille (2).

5. Une installation, conformément à la Revendication 2, dans laquelle ces moyens d'imprimerie comportent un cylindre pour rotogravure (3) de sorte que la couche de résine transparente est déposée sur cette feuille (2) avant d'entrer en contact avec le cylindre à graver (4).

6. Une installation, conformément à la Revendication 2, dans laquelle ces moyens d'imprimerie, gravure et polymérisation forment un ensemble compact (20) qui est agencé aligné sur une rotative (21) qui comporte d'autres moyens d'imprimerie pour imprimer d'autres motifs et couleurs (a, b, c, d et e) sur cette feuille, cet ensemble (20) étant capable d'obtenir la gravure simultanément à ces autres motifs et couleurs (a,b,c,d et e).

7. Une installation, conformément à la Revendication 2, dans laquelle ces moyens de polymérisation comportent des rayons ultraviolets (18) ou un générateur d'électrons.

8. Une installation, conformément à la Revendication 7, dans laquelle ces rayons ultraviolets comportent un filtre pour les rayons infrarouges (19).

9. Une installation, conformément à la Revendication 7, dans laquelle ces moyens de polymérisation sont agencés à l'extérieur de ce cylindre à graver (4).
